# EUROPEAN PATENT APPLICATION

(11) **EP 0 545 363 A1**
(43) Date of publication of application: **09.06.1993**
(21) Application number: 92120493.9
(22) Date of filing: 01.12.1992
(51) Int. Cl.: H01L 21/329, H01L 21/82, H01L 27/06

(54) **Integrated circuit fabrication process and structure**

(30) Priority: 06.12.1991 US 802878
(71) Applicant: NATIONAL SEMICONDUCTOR CORPORATION, Santa Clara, California 95052-8090 (US)
(72) Inventor: Robinson, Murray J., Falmouth, Maine 04101 (US); Joyce, Christopher C., Gorham, Maine 04106 (US)
(74) Representative: Sparing Röhl Henseler Patentanwälte

(57) **Abstract**

A high definition, high resistance resistor structure is formed in a resistor PWell by shallowly implanting a well-defined resistive region of the resistor PWell with relatively fast-diffusing N type atoms in an N⁻ concentration, and shallowly implanting a well-defined resistor contacts regions with relatively slow-diffusing N type atoms in an N⁺ concentration. The high definition, high resistance resistor structure (2) fabrication steps are integrated into MOS transistor structure fabrication steps without adding any new steps to the process. The resistor PWell is formed at the same time as the MOS transistor structure PWell, the resistive region is implanted at the same time as the low density drain (LDD) regions for the MOS device, and the resistor contacts regions are implanted at the same time as the source and drain regions of the MOS transistor structure. MOS transistor masks are modified to include a resistor PWell definition opening, a resistive region definition opening, resistor contacts regions definition openings, and resistor contacts definition openings.

## Description

This invention relates to a new high definition, high resistance resistor structure that may be coupled to integrated circuit structures. More particularly, the invention is applicable to CMOS and BICMOS transistor structures and provides a new process for fabrication of new CMOS and BICMOS integrated circuit structures that include the new resistor structure. The invention uses selected mask sequences from the CMOS transistor structure fabrication steps with modification of the masks according to the invention to form the new resistor structure.

In the fabrication of advanced CMOS transistor structures, including BICMOS structures, the respective gates are used for self-alignment of corresponding sources and drains. It is a goal to provide tight control of the dimensions of these structures and to minimize dimensions to the greatest extent possible. Furthermore, it is a goal to place active elements at or near the surface of the structure. In many cases, it is desirable to utilize a resistor in connection with integrated circuit structures in order to enhance circuit design capability.

Prior art CMOS transistor structures, combining complementary NMOS and PMOS transistor structures, are fabricated, for example, on a P type substrate of semiconductor material by first forming a PWell and an NWell using conventional mask, etch and implant sequences. An N⁺ concentration of relatively fast diffusing N type atoms is implanted to form an NWell "bed" and a P⁺ concentration of relatively fast diffusing P type atoms is implanted to form a PWell "bed."

An epitaxial layer in the form of a single crystal N type semiconductor material is then deposited over both the NWell and the PWell. Both wells are then retrograde-diffused to the surface of the epitaxial layer by conventional diffusion processing means. Isolation oxide layers are formed about the CMOS transistor structure by conventional mask, etch and formation sequences so as to isolate the CMOS from adjacent structures. The transistor structure is also framed by field oxide regions formed at the upper surface of the isolation regions using a field oxide region definition mask. P type channel stop layers formed at the same time as the PWell, underlie the isolation oxide regions contacting both the NWell and PWell. The channel stop regions act to isolate the wells from parasitic MOS effects caused by adjacent structures.

Formation of the completed CMOS transistor structure requires the introduction of a gate, a source, and a drain to the NMOS and PMOS elements of the complementary transistor structure. The gates may be formed of a polycrystalline layer of semiconductor material, using a conventional mask, etch and deposition sequence. These poly gates are located above the source, drain and channel regions of each well. The poly gates are isolated from the channel regions by a gate oxide layer. The gate is formed of polycrystalline silicon because that material can withstand subsequent annealing temperatures on the order of 1000-1100°C and the gate can therefore be used to accurately align the transistor's source and drain contacts.

The source and drain regions are preliminarily formed and defined by first implanting a relatively fast-diffusing N type atom using conventional mask, etch and implant sequences. A gate definition mask opening in the polycrystalline layer defines the location of the shallow source and drain regions, which are separated by the MOS gate channel. Shallow regions ensure increased circuit speed and reliability. This first implantation serves two functions: 1) it acts as a low dose drain (LDD) region to minimize hot electron effects; and 2) it initiates source and drain site definition. A second implantation of a relatively slow-diffusing N type atom further defines the contact regions of the source and drain. The contact regions are formed by conventional mask, etch and implanting sequences.

As previously noted, it may be desirable to provide a resistor for coupling to integrated circuit structures depending upon the circuit design. Generally, prior art resistor structures are fabricated in processes that are separate and distinct from CMOS transistor structure fabrication processes, and thus, such structures are more of an "add-on" rather than an integrated part of CMOS or BICMOS fabrication steps. Furthermore, such prior art resistors are not highly defined spatially. The sheet resistance for prior art resistors such as base resistors is generally about 600-700 ohms/sq, less than the typical 2000-3000 ohm resistance values desired for some circuit resistors. The circuit designer must therefore increase the resistor dimensions. Also, such prior resistors as buried layer resistors and pinched layer resistors are fabricated by methods involving steps that drive the resistor well below the surface of the structure. Deep resistors are undesirable, particularly with the new, faster advanced CMOS devices, because the effective operational temperature range of the resulting resistor is narrower than the desired operational range of the circuit as a whole.

Advances in CMOS transistor structure fabrication techniques have yielded greater miniaturization and higher performance of such structures, especially when the CMOS fabrication is part of BICMOS (integrated bipolar transistor and CMOS transistor) fabrication. Prior structures have been fabricated on a nominal 2.5 micron scale--that is, the effective gate channel length, L_{eff} (rather than the dimensional channel length, L), is nominally 2.5 microns. Advanced device designs taking advantage of further miniaturization have led to L_{eff} being reduced to below 1.0 micron nominal. With this advance in miniaturization comes additional problems.

One of the major problems involves the increased difficulties associated with hot electron effects in the gate channel. This effect essentially involves the "trapping" of electrons flowing from the source to the drain, whereby the electrons are of a sufficiently high enough energy state that they jump from the channel into the dielectric barrier located between the transistor's gate and its channel. Over time, the transistor's operational characteristics decline as more and more electrons enter the dielectric and the transistor's threshold voltage level increases. It is well-known that the degradative effect of this electron trapping increases as the channel length is reduced. While it is desirable to have smaller channel lengths, hot electron effects cause the source-drain potential difference to decrease. This decrease acts to increase L_{eff} and the effective miniaturization of the circuit is negated. Therefore, in 1.0 micron technology, these hot electron effects are of much more concern than they have been in 2.5 micron technology, particularly when there is no desire to reduce the power supply voltage.

There are several methods possible to overcome hot electron effects associated with further reductions in L_{eff}. All feasible methods involve reducing the lateral component of the electric field strength in the channel and improving the fabrication of the source and drain regions. One means presently related to both aspects involves utilizing a relatively slow diffusing atom to form the source and drain regions. Combining a slow diffusing atom with a faster diffusing one further ensures a more gradual transition from source or drain to the channel region. This combination requires extremely precise fabrication steps. Another technique, the insertion of the low-dose drain or LDD structure, essentially involves two implantation steps as well, but the gradual transition is achieved by reducing the magnitude of the first implantation dose and utilizing mask and etch sequences that define the source and drain regions.

Self-alignment of the source and drain regions utilizing the gate to align the source and drain for the gate ensures that those regions are well defined. This is a particularly important step as the channel size is reduced. Present advanced fabrication steps ensure that the self-aligned regions of CMOS transistor structures are well defined. However, the fabrication techniques used to form resistor structures for example, have not been subject to the high-quality requirements associated with the advanced CMOS structures. Thus, when a reduced, shallow, well defined advanced integrated circuit structure is connected to a less well defined, deeper structure, such as a pinched layer resistor, the potential capability of the advanced structure is not fully realized. It is limited by the buried structure parameters.

Therefore, what is needed is an advanced resistor structure that may be coupled to an integrated circuit structure. Furthermore, what is needed is an advanced resistor structure that may be coupled to an integrated circuit structure in which the resistor is highly-defined and highly-resistant. What is also needed is a highly-defined, highly-resistant resistor structure that is operational over a wide temperature range. Still further, what is needed is an advanced resistor structure that may be formed by integrating the fabrication steps with advanced CMOS and BICMOS transistor structure fabrication sequences. These needs are addressed by the present invention as defined in the claims. The invention allows to achieve at least one of the following advantages:
Provision of an advanced resistor structure that may be coupled to advanced integrated circuit structure, wherein the resistor is highly-defined, highly-resistive, and operational over a wide temperature range.

Provision of a new resistor structure that may be coupled to an integrated circuit structure wherein the integrated circuit structure may include an advanced CMOS or advanced BICMOS transistor structure.

Integration of the fabrication of the high definition, high resistance resistor into the sequence utilized in fabricating advanced CMOS and advanced BICMOS integrated circuits.

Integration of the fabrication of the highly-defined, highly-resistive resistor into the fabrication sequences for advanced CMOS and advanced BICMOS integrated circuits using CMOS and BICMOS sequences modified to form the novel resistor structure. The present invention provides new mask structures and new mask, etch, implant and oxidation process sequences for fabricating the new structure in advanced CMOS and BICMOS integrated circuits without increasing the number of processing steps.

The preferred embodiment may be summarized as follows:
In order to achieve the above objectives, there is provided a shallow, high definition, high resistance resistor structure that is formed utilizing fabrication steps associated with the formation of advanced CMOS and BICMOS transistor structures. The high definition resistor structure comprises relatively fast diffusing atoms forming a first type semiconductor material, implanted in a resistor well of second type semiconductor material, wherein the atoms may be N type and the resistor well of a P type. Shallow contact regions at the ends of the resistor are formed by implanting relatively slow diffusing N type atoms in an N⁺ concentration. In the preferred example of the invention, the relatively fast diffusing N type atoms are phosphorus atoms implanted to an N concentration at the surface of the PWell, and the relatively slow diffusing atoms are Arsenic atoms. In the preferred example, the new resistor structure has a width no greater than 2.0 microns.

Of importance is the incorporation of the fabrication of the resistor structure into the fabrication sequence for advanced CMOS and BICMOS integrated circuits. In the transistor fabrication steps, the PWell of the CMOS transistor structure is formed by implanting a P⁺ concentration of relatively fast-diffusing atoms into a substrate of P type semiconductor material. After an epitaxial layer of N type semiconductor material has been grown over the substrate, the P type "bed" of atoms, and a complementary "bed" of N type atoms, a selective mask, etch and diffusion sequence results in the retrograde diffusion of the P- and N type atoms such that the PWell and the NWell of the CMOS transistor are formed.

It is possible to provide for the simultaneous formation of a resistor PWell "bed" of atoms by modifying the CMOS PWell mask to include a resistor PWell-defining opening in the CMOS PWell mask. The resistor PWell is then formed through the same mask, etch and diffusion sequence used for the CMOS transistor PWell. Isolation oxide regions are formed about the structure subsequent to the retrograde diffusion of the wells.

As previously noted, one method of minimizing hot electron effects in advanced CMOS transistor structures is to lightly dope the structure with N type atoms, forming the LDD regions. In current advanced CMOS and BICMOS processes this is achieved by implanting the upper level of both the NWell and the PWell with N type atoms in a self-aligned and spatially highly-defined orientation prior to formation of the source and drain regions of the particular MOS. This lightly doped implantation, or LDD implantation, proceeds subsequent to the formation of the MOS gate.

In the present description the gate for both MOS structures is referred to as a poly gate because it is formed from a layer of a polycrystalline semiconductor material. The polycrystalline layer is first blanket deposited on the entire surface of the epitaxial layer, as well as on the isolation oxide regions and field oxide regions located at structure interfaces. Specifically, the poly gates are formed by a mask and etch sequence that sharply defines the self-aligned source and drain regions of the advanced transistor structure. In the preferred embodiment of the invention, the effective gate channel length, L_{eff}, achievable in advanced CMOS and BICMOS fabrication is about 0.5 to 0.8 microns. The gate acts as a mask during the implantation of the N type atoms used to form the shallow LDD regions. This "gate mask" self-aligns and highly defines the source, drain and channel regions of the underlying epitaxial layer, as well as the LDD implant.

The preferred embodiment provides for the formation of the advanced resistor by modifying the CMOS poly gate mask to include a highly-defined, self-aligned resistor opening in the CMOS poly gate mask over the resistor PWell. The resistor is formed through the same implantation sequence used for the formation of the shallow LDD regions.

The same steps used to form the LDD regions are utilized. However, the highly-defined resistor opening in the CMOS poly gate mask does not mask the poly where the gate would normally be located. Instead, the area that would normally serve as the gate channel region in the epitaxial layer of the resistor PWell is laid open for implantation of the N type atoms used to form the shallow, highly defined LDD. This new structure, a shallow, lightly doped region that extends over the entire surface of the resistor PWell, is the new high definition, high resistance resistor.

The fabrication of the high definition, high resistance resistor structure is completed by the formation of the resistor contacts. The resistor contacts are formed by implanting the same relatively slow-diffusing N type atoms of N⁺ concentration utilized in the mask, etch and implant sequences of the NMOS source and drain region formation. The N⁺ source/drain NMOS mask is further modified to include resistor contact region-defining openings. Contact and metallization masks are also modified to include resistor contact and metallization definition openings.

In addition to the new high definition, high resistance resistor structure and the new CMOS and BICMOS fabrication processes, the present invention also provides new CMOS and BICMOS integrated circuit photodefinition masks. This includes a new PWell definition mask also forming the resistor PWell definition mask, a new poly gate definition mask also forming the resistor definition mask, a new NMOS source/drain definition mask also forming the heavily-doped resistor regions definition mask, a new CMOS contact definition mask also forming resistor contact regions, and a new Metal 1 definition mask also forming a new resistor Metal 1 contacts definition mask.

Figure 1 is a simplified diagrammatic elevation view of the high definition, high resistance resistor structure of the present invention and an accompanying CMOS transistor structure.

Figure 2 is a simplified diagrammatic elevation view of the 3.0 mask, etch and implant sequence of the CMOS fabrication process showing the new 3.0 PWell definition mask with CMOS NWell and PWell definition openings and the new resistor PWell definition opening for the resistor structure.

Figure 3 is a simplified diagrammatic elevation view of the 3.0 mask epitaxial growth step showing the retro NWell and retro PWell of the CMOS transistor structure, the new resistor PWell structure, and channel stop regions adjacent to all wells.

Figure 4 is a simplified diagrammatic elevation view of the 6.0 mask, etch and isolation oxidation step showing the diffused NWell and PWell of the CMOS transistor structure and the diffused resistor PWell of the new resistor structure.

Figure 5 is a simplified diagrammatic elevation view of the 6.0 mask field oxidation step showing the framing field oxide regions for the CMOS transistor structure and for the resistor structure.

Figure 6 is a simplified diagrammatic elevation view of the 7.0 poly mask blanket deposition step showing the deposited polycrystalline silicon layer over the CMOS transistor structure NWell and PWell and over the resistor PWell.

Figure 7A is a simplified diagrammatic elevation view of the 8.0 mask and etch step showing the new 8.0 gate definition mask with LDD definition openings for the CMOS transistor structure and also functioning as a resistor structure definition mask with a resistor structure definition opening for the new resistor structure.

Figure 7B is a simplified fragmentary diagrammatic plan view of the new 8.0 gate definition mask of Figure 7A.

Figure 8 is a simplified diagrammatic elevation view of the 8.0 mask, etch and implant step showing the implantation of N type atoms through the LDD definition openings of the new 8.0 gate definition mask and also showing the implantation of the same N type atoms through the resistor structure definition openings of the new 8.0 gate definition mask.

Figure 9A is a simplified diagrammatic elevation view of the 13.0 mask, etch and implant step showing the new 13.0 NMOS source/drain definition mask with source/drain definition openings for the NMOS transistor structure and also functioning as a resistor contacts definition mask with a resistor contacts region definition opening for the resistor structure.

Figure 9B is a simplified fragmentary diagrammatic plan view of the 13.0 mask, etch and implant step showing the new 13.0 NMOS source/drain definition mask of Figure 9A.

Figure 10 is a simplified diagrammatic elevation view of the 14.0 contact definition mask, etch and deposition step showing the new Metal 1 definition mask with Metal 1 deposition definition openings and also functioning as a resistor Metal 1 contacts definition mask with a resistor Metal 1 definition opening for the resistor structure, using a low temperature oxide as the Metal 1 definition mask.

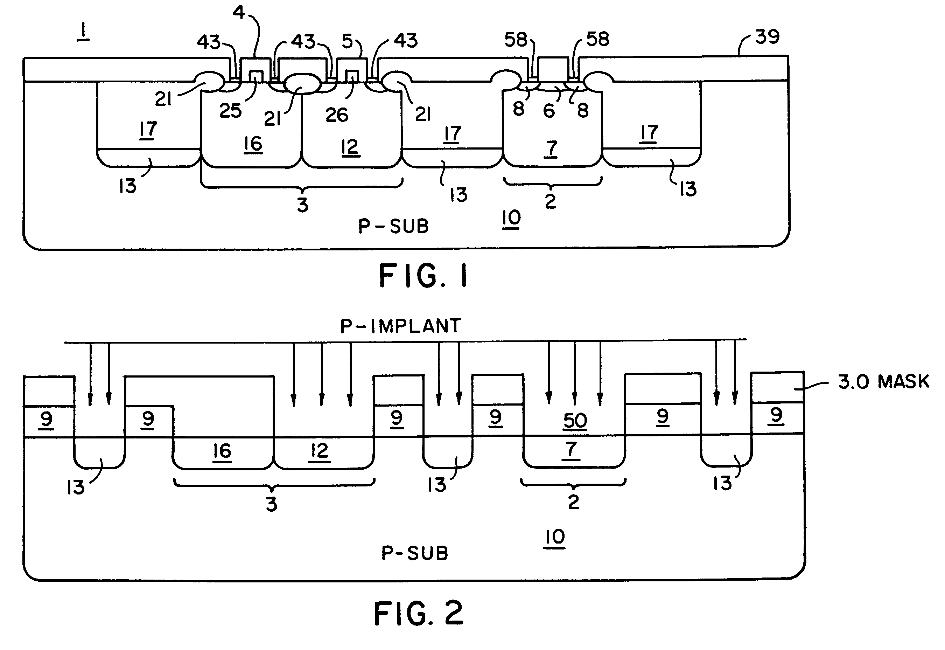

A new MOS transistor and resistor structure **1** according to the present invention is illustrated in FIG. 1. Said transistor and resistor structure **1** includes a new resistor structure **2** that may be coupled either to an input or an output of an advanced CMOS transistor structure **3**, wherein said CMOS transistor structure **3** is a complementary pair of transistors, including a PMOS transistor **4** and an NMOS transistor **5**. A shallow, self-aligned and highly-defined resistive region **6** of said resistor structure **2** is formed of N type atoms, preferably Phosphorus, with a sheet resistance of about 1600 ohms/sq. Said resistor structure **2** includes a resistive region **6**, a retrograde resistor PWell region **7** and resistor contact regions **8**. The sheet resistance of said resistor structure **2** exceeds that of similar prior art resistors by 2 to 3 times because the concentration of said N type atoms used to form said resistive region **6** is only about one-third of the concentration generally used.

The fabrication process used to form said resistor structure **2** has been integrated into the CMOS fabrication steps of a new BICMOS fabrication process without adding any new steps. The new CMOS fabrication process is hereafter described and those steps related to the fabrication of said resistor structure **2** are illustrated in FIGS. 2-10. The new CMOS mask structures are also shown in these figures. The overall CMOS transistor structure mask sequence can be summarized as follows:

| Mask No. | Mask Function |
|---|---|
| 2.0 | Retro NWell Definition Mask |
| 3.0 | Retro PWell/Channel Stop Definition Mask |
| 4.0 | Isolation Oxide Definition Mask |
| 5.0 | Isolation Oxide Gettering Mask |
| 6.0 | CMOS Active Area Definition Mask |
| 7.0 | Active Strip Mask |
| 8.0 | Poly Gate Definition Mask |
| 12.0 | P⁺ Source/Drain Definition Mask (PMOS) |
| 13.0 | N⁺ Source/Drain Definition Mask (NMOS) |
| 14.0 | CMOS Contact Definition Mask |
| 15.0 | METAL 1 (M1) Definition Mask |
| 17.0 | METAL 2 (M2) Definition Mask |
| 18.0 | Passivation Definition Mask |

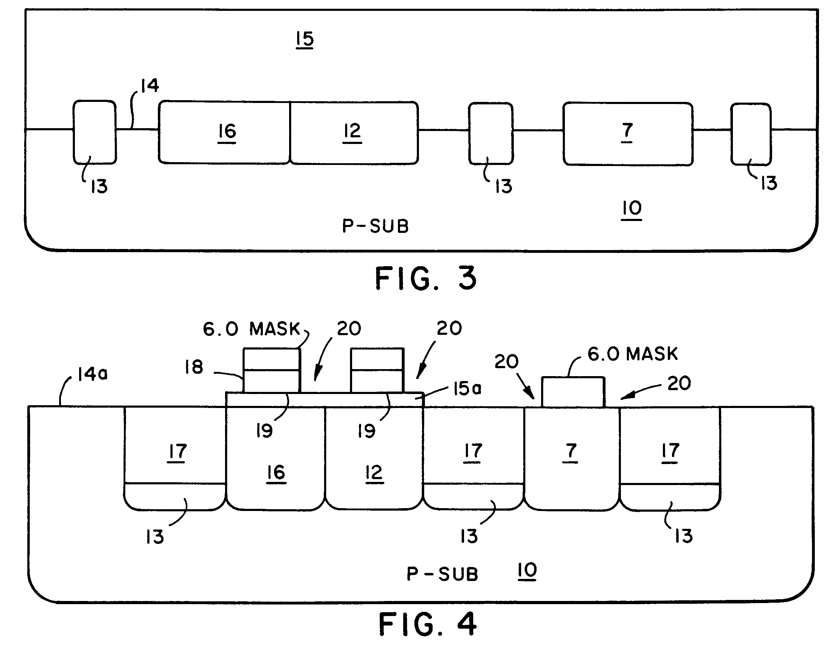

Prior to the fabrication sequences used to form said MOS transistor and resistor structure **1** of the present invention, an initial oxide layer **9** is grown from a substrate **10** of P type semiconductor material to a depth of about 4000Å. An oxide photoresist layer is then deposited on said initial oxide layer **9** to form the 2.0 mask (not shown). The 2.0 mask, etch and implant sequence is used to form a retro NWell region **16**. Referring to FIG. 2, the 3.0 mask, etch and implant sequence is used to define and implant a retro PWell region **12** of said CMOS transistor structure **3** and channel stop regions **13** that are adjacent to other active structures (not shown). In the preferred embodiment of the invention, the 3.0 mask is modified to include a resistor PWell definition opening **50** for implanting said resistor retro PWell region **7**. Boron atoms are implanted to a P⁺ concentration in said retro PWell region **12**, said channel stop regions **13** and said resistor retro PWell region **7**. The Boron implantation is preferably achieved at 1.15x10¹⁴ ions/cm² @ 120 Kev. A single crystal epitaxial layer **15** of N⁻ silicon is then deposited uniformly over a first integrated circuit structure surface **14** in a blanket epitaxial deposition. In the thermal cycle of the formation of said epitaxial layer **15** said retro NWell region **16**, said retro PWell region **12**, and said resistor PWell region **7** up-diffuse to some extent, as illustrated in FIG. 3.

Isolation oxide regions **17** are established around said CMOS transistor structure **3** and said resistor structure **2** using the 4.0 mask, etch and oxidation growth sequence. Said isolation oxide regions **17** diffuse to meet said channel stop regions **13**, pinching any potential channel in that location. The oxidation process further causes upward diffusion of said retro NWell **16**, said retro PWell **12**, and said resistor PWell **7**. Among other things, the 5.0 mask is used to implant said isolation oxide regions **17** with an N⁺ concentration of phosphorus atoms as a gettering agent. A uniform nitride layer **18** is deposited in a blanket chemical vapor deposition across a second integrated circuit structure surface **14a**, wherein a thin epitaxial layer **15a** is also formed.

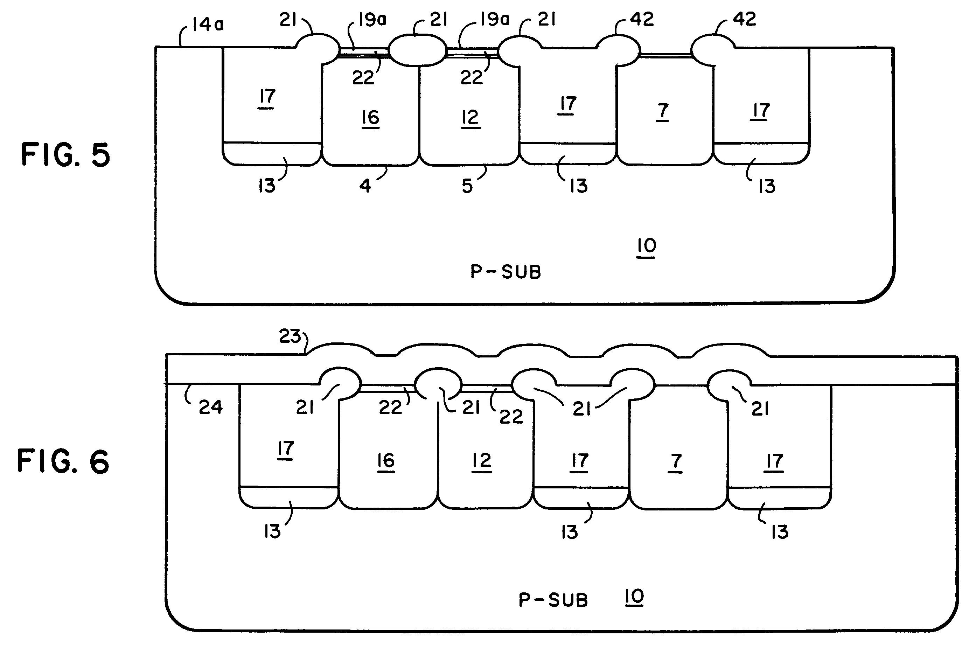

Referring to FIG. 4, the 6.0 active mask is formed for etching said nitride layer **18** and defining active regions **19** of said CMOS transistor structure **3** and said resistor structure **2**. Openings **20** in the 6.0 mask define first field oxide regions **21** for framing said CMOS transistor structure **3** and said resistor structure **2** during subsequent oxidation steps. As illustrated in FIG. 5 , said field oxide regions **21**, which add about 1000Å to the thickness of said isolation oxide regions **17**, isolate said PMOS transistor **4** from said NMOS transistor **5**. A second field oxide region **42** isolates said CMOS transistor structure **3** from said resistor structure **2**, forming a second frame about said resistor structure **2**.

In the 7.0 active strip mask and etch steps, and with reference to FIG. 5, said nitride layer **18** is stripped from all surfaces and CMOS transistor active regions **19a** are opened to expose said epitaxial oxide layer **15a**. Said epitaxial oxide layer **15a** is consumed in an oxidation step to form a thin gate oxide layer **22** in said transistor active regions **19a**. As illustrated in FIG. 6, a blanket layer of polycrystalline silicon (poly) **23** is then chemically vapor-deposited over a CMOS transistor/resistor surface **24** to a depth of about 3500Å, with doping as necessary to adjust the threshold voltage for said CMOS transistor structure **3**.

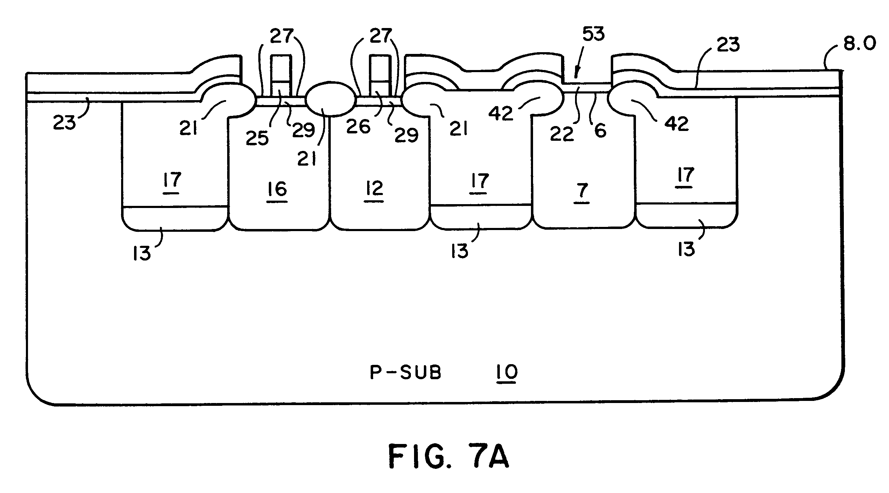

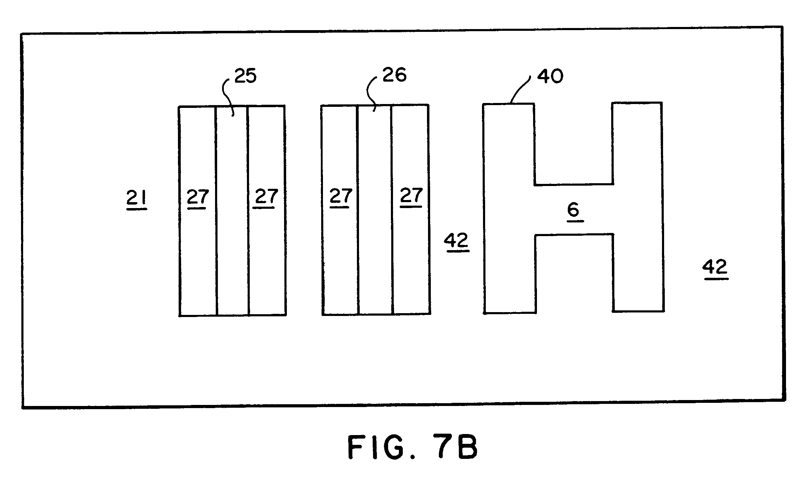

Referring to FIGS. 7A and 7B, the 8.0 poly gate definition mask and etch steps define an NWell poly gate **25** and a PWell poly gate **26** of said CMOS transistor structure **3**, located between said first field oxide regions **21**. The 8.0 poly gate definition mask steps define both poly gates **25** and **26** using a photoresist layer and photolithographic stepper followed by etching said poly layer **23** and leaving behind said poly gates **25** and **26** over said gate oxide layer **22** of said CMOS transistor structure **3**. In advanced BICMOS fabrication, the 8.0 gate definition mask is designed to tightly control the dimensions of low density drain (LDD) definition openings **27** between said first field oxide regions **21**. It also provides for self-alignment of said poly gates **25** and **26**. In the preferred embodiment of the invention the 8.0 mask is modified to include a resistor region opening **53** for implanting said resistive region **6**, and for etching said gate oxide layer **22** formed on the surface of said resistor PWell **7**. Said resistor region opening **53** forms a highly-defined poly frame **40**, setting the dimensions of said resistive region **6** and said resistor contacts **8** of said resistor PWell region **7**. Said resistor region opening **53** is completely open, providing no gate for said resistor PWell **7**.

A gate seal oxide layer **28** is grown over said gate oxide layer **22** and said poly gates **25** and **26**, wherein said gate seal oxide layer **28** acts as a standoff, or spacer, for transistor channels **29** underlying said poly gates **25** and **26**. Said gate oxide seal layer **28** is preferably grown to a thickness of about 400Å over said poly gates **25** and **26**, at a temperature of about 900°C, in order to provide highly-defined gates that have length dimensions, L, of about 2.0 microns. This corresponds to effective channel lengths L_{eff} in the range from 0.5 to 0.8 micron. Said resistor region opening **53** provides said resistive region **6** with the same dimensions as said transistor channels **29** and the 8.0 mask is used to mask said resistive region **6** to prevent the formation of said gate seal oxide layer **28** in that region.

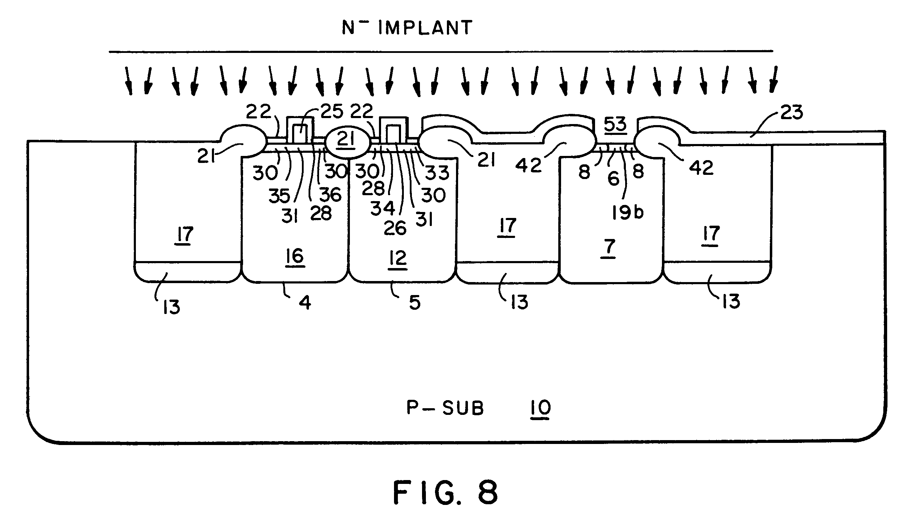

Referring to FIG. 8, the 8.0 poly gate definition mask, etch and implant sequence is also used to define and implant low density drain (LDD) regions **30** in said LDD definition openings **27**, wherein said LDD regions **30** are used to reduce hot electron effects. In particular, said first field oxide regions **21** and said poly gates **25** and **26** with gate oxide seal layer **28** define the location of said LDD regions **30**. Relatively fast-diffusing Phosphorus atoms are implanted to an N⁻ concentration in those sections of said transistor active regions **19a** not masked by said poly gates **25** and **26**. The LDD Phosphorus implantation is preferably conducted at a level of 1.3x10¹³ ions/cm² @ 60 Kev. This implantation is conducted at two angles, an angle of about +7° from the perpendicular to the plane of the surface of said CMOS transistor structure **3**, and an angle of about -7° from the same perpendicular. The implantation of said LDD **30** through said gate oxide layer **22** and into said epitaxial layer **15** is done at an angle and at double dose in order to negate the shadowing effects caused by sealed poly gates **25** and **26**. In this way, a portion of said transistor active regions **19a** are lightly doped, thereby providing a gradual transition from poly gate source regions **33** and **35**, through gate channel regions **31** and into drain regions **34** and **36** so as to further reduce hot electron effects. In the preferred embodiment of the invention, the LDD Phosphorus is also implanted through said resistor region opening **53** of the modified 8.0 mask, thereby shallowly doping a resistor active region **19b** of said resistor PWell **7** to form said resistive region **6** and initially defining said resistor contacts **8**.

Subsequent annealing at about 1000°C drives the low dose phosphorus implant to a depth of about 1500-2000Å into said epitaxial layer **15** in said active regions **19a** and **19b**. Although this drive is relatively deep, it still provides a resistor that is much shallower than prior art resistors. Furthermore, the sheet resistance of said resistor region **6** is much higher than prior art structures because said LDD regions **30** are doped at a concentration about one-third less than prior art LDD implants. In this way, the tightly-controlled 8.0 mask is utilized, along with very low doping levels, to form said resistive region **6** with a sheet resistance that is not only highly-defined, but that is also highly-resistant.

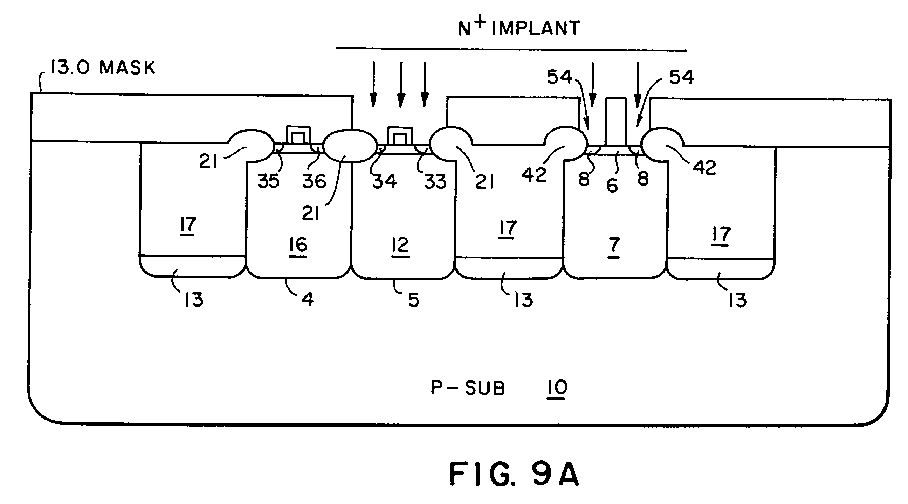

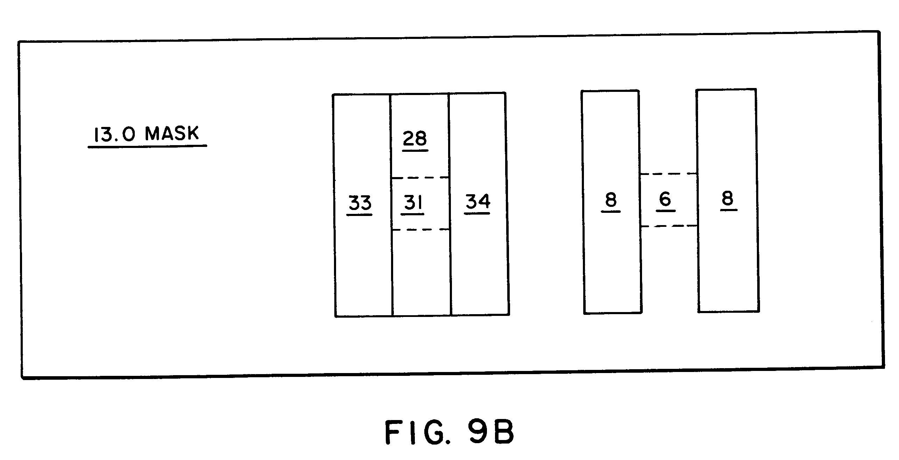

The 12.0 mask, etch, and implant sequence is used to define a P⁺ PMOS source region **35** and a P⁺ PMOS drain region **36** of said PMOS transistor **4**. In the preferred embodiment of the invention Boron Difluoride (BF₂) molecules are implanted through the 12.0 mask at a concentration of 3.0x10¹⁵ ions/cm² @ 65 Kev. Referring to FIGS. 9A and 9B, the 13.0 mask, etch and implant sequence is used to define and implant N⁺ NMOS source region **33** and N⁺ NMOS drain region **34** of said NMOS transistor **5**. In the preferred embodiment of the invention, Arsenic atoms are implanted through the 13.0 mask at a concentration of 7.0x10¹⁵ ions/cm² @ 100 Kev. In the preferred embodiment of the invention, the 13.0 mask is modified to include resistor contacts openings **54** for implanting said resistor contacts **8**. Said resistor contacts openings **54** provide said resistor contacts with the same dimensions as said NMOS source region **33** and said NMOS drain region **34**, both of which are well-defined. Said resistor contacts **8** utilizing the same implantation step involved in the formation of said NMOS source region **33** and said NMOS drain region **34**.

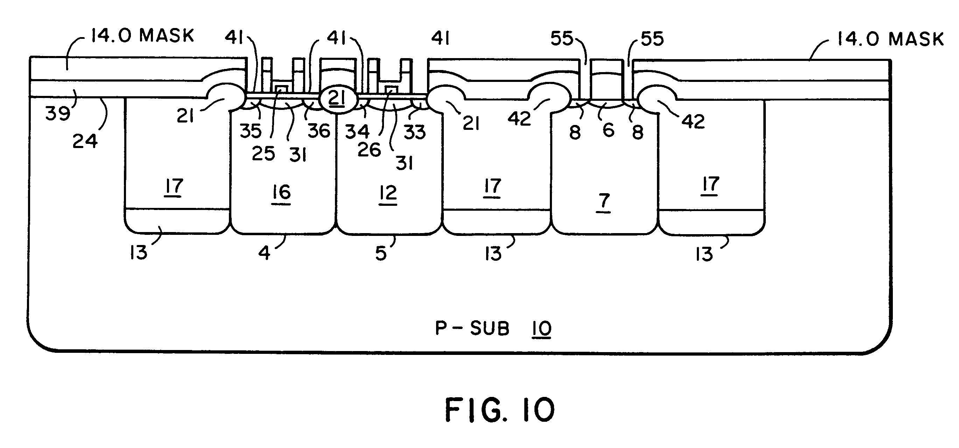

Following the source and drain mask, etch and implant sequences of masks 12.0 and 13.0 for said PMOS transistor **4**, said NMOS transistor **5** of said CMOS transistor structure **3**, and said resistor structure **2**, a blanket low-temperature oxide layer (LTO) **39** is blanket-deposited over said CMOS transistor/resistor surface **24**, including said poly frame **40**. Referring to FIG. 10, the 14.0 CMOS contact definition mask and etch sequence removes said LTO **39** over CMOS metal contact areas **41** corresponding to said source regions **33** and **35** and said drain regions **34** and **36**. In the preferred embodiment of the invention, the 14.0 mask is modified to include a resistor contacts formation region **55** in preparation of the Metal 1 deposition. Preferably, said CMOS metal contact areas **41** and said resistor contacts formation region **55** are formed by a Platinum deposition step. In subsequent mask steps a first metal layer **43** is deposited using the Metal 1 mask and deposition sequence followed by deposition of a second metal layer using the 17.0 Metal 2 mask and deposition sequence. The 15.0 Metal 1 deposition mask is modified to include a resistor Metal 1 definition opening **57** for depositing resistor Metal 1 contacts **58**.

While the invention has been described with reference to particular example embodiments, it is intended to cover all modifications and equivalents within the scope of the following claims.

## Claims

1. An integrated circuit fabrication process for fabricating a high definition, high resistance resistor structure while also fabricating a CMOS transistor structure, said CMOS transistor structure comprising a PMOS transistor and an NMOS transistor formed in an epitaxial layer of N type semiconductor material deposited over a P type substrate, wherein said PMOS transistor and said NMOS transistor each has a source region, a drain region and a transistor channel region located between said source region and said drain region, wherein said NMOS transistor has an NMOS gate formed above an NMOS channel region and separated from said NMOS channel region by a gate oxide layer, and said PMOS transistor has a PMOS gate formed above a PMOS channel region and separated from said PMOS channel region by said gate oxide layer, wherein said NMOS transistor and said PMOS transistor are framed by first field oxide regions; said high definition, high resistance resistor comprising a resistive region and self-aligned resistor contacts formed in said epitaxial layer of N type semiconductor material, and a resistor PWell underlying said resistive region and said resistor contacts, said resistor structure being framed by a second field oxide region, wherein said CMOS transistor structure is fabricated by a process comprising the steps of:
a. forming a PWell of said CMOS transistor in said P type substrate using a PWell definition mask and etch sequence and implanting relatively fast-diffusing P type atoms through a PWell-defining opening in said PWell definition mask;
b. depositing said N type epitaxial layer over an NWell of said CMOS transistor and over said PWell;
c. depositing a polycrystalline layer of semiconductor material over said CMOS transistor structure and said first field oxide regions;
d. forming said PMOS gate and said NMOS gate from said polycrystalline layer using a poly gate definition mask and etch sequence;
e. forming LDD regions in said PMOS transistor and said NMOS transistor using said poly gate definition mask to shallowly implant relatively fast-diffusing N type atoms through LDD region definition openings of said poly gate definition mask, through said gate oxide layer and into said NWell and said PWell, wherein said NMOS gate and said PMOS gate mask the implantation of said relatively fast-diffusing N type atoms into said NMOS channel region and said PMOS channel region respectively;
f. forming NMOS source and drain regions using an NMOS source and drain mask and etch sequence and implanting relatively slow-diffusing N⁺ type atoms into said LDD regions of said NMOS transistor through an NMOS source and drain region-definition opening of said NMOS source and drain definition mask;
g. forming self-aligned CMOS source and drain contacts of said PMOS source and drain regions and NMOS source and drain regions using a CMOS source and drain contacts definition mask, etch and deposition sequence; and
h. depositing a refractory metal on said CMOS source and drain contacts of said CMOS transistor structure, wherein said refractory metal is deposited by a Metal 1 contact definition mask, etch and deposition sequence;
the improvement comprising the steps of:
a. modifying the step of forming said PWell to include the formation of a resistor PWell by simultaneously implanting said relatively fast-diffusing P type atoms through a resistor PWell defining opening in said PWell definition mask and into said substrate;
b. modifying the step of depositing said polycrystalline layer of semiconductor material over said CMOS transistor structure and said first field oxide regions to include blanket-depositing said polycrystalline layer over said resistor PWell and said second field oxide region;
c. modifying the step of forming said LDD regions to include the formation of said resistive region by simultaneously shallowly implanting said relatively fast-diffusing N type atoms through a resistive region-definition opening in said poly gate definition mask and into said resistor PWell;
d. modifying the step of forming said NMOS source and drain regions to include the formation of resistor contact regions by simultaneously implanting said relatively slow-diffusing N⁺ type atoms through resistor contact regions-definition openings of said NMOS source and drain definition mask;
e. modifying the step of forming said self-aligned CMOS source and drain contacts to include the formation of said self-aligned resistor contacts by modifying said CMOS source and drain contacts definition mask to include self-aligned resistor contacts definition openings; and
f. modifying the step of depositing a refractory metal on said CMOS source and drain contact regions to include depositing said refractory metal on said self-aligned resistor contacts, by modifying said Metal 1 contact definition mask to include resistor contacts Metal 1 definition openings.

2. A high definition, high resistance resistor comprising a resistive region formed of a lightly-doped shallow surface region of semiconductor material in an epitaxial layer.

3. The high definition, high resistance resistor as claimed in Claim **2** wherein said resistive region is formed of a first-type semiconductor material in a well of second-type semiconductor material.

4. The high definition, high resistance resistor as claimed in Claim **3** wherein said first type semiconductor material comprises a low-concentration of relatively fast-diffusing N type atoms.

5. The high definition, high resistance resistor as claimed in Claim **4** wherein said relatively fast-diffusing N type atoms used to form said resistive region are Phosphorus atoms.

6. The high definition, high resistance resistor as claimed in Claim **2** wherein said high definition, high resistance resistor is coupled to an integrated circuit structure.

7. A high definition, high resistance resistor comprising:
a. a shallow resistive region of a first type semiconductor material in a well of a second type of semiconductor material;
b. resistor contact regions formed by heavily doping said first type semiconductor material, wherein said resistive region of first type semiconductor material lies between said resistor contact regions; and
c. self-aligned resistor contacts affixed to said resistor contact regions, wherein said self-aligned resistor contacts are formed of a refractory metal.

8. The high definition, high resistance resistor as claimed in Claim **7**, said two resistor contact regions comprising N⁺ concentration regions of relatively slow-diffusing N type atoms overlying said first type semiconductor material.

9. The high definition, high resistance resistor as claimed in Claim **8** wherein said relatively slow-diffusing N type atoms are Arsenic atoms.

10. The high definition, high resistance resistor as claimed in Claim **7** coupled to an integrated circuit, said integrated circuit comprising an MOS transistor structure, said MOS transistor structure comprising a shallow low density drain (LDD) region formed in an MOS well of said second type semiconductor material, wherein said LDD region and said resistive region are both formed of said first type semiconductor material.

11. A high definition, high resistance resistor structure coupled to an integrated circuit, said integrated circuit comprising an CMOS transistor structure, said CMOS transistor structure comprising a PMOS transistor and an NMOS transistor formed in an epitaxial layer of N type semiconductor material deposited over a P type substrate, wherein said PMOS transistor and said NMOS transistor each has a source region, a drain region, a transistor channel region located between said source region and said drain region and low density drain (LDD) regions, wherein said NMOS transistor has an NMOS gate formed above an NMOS channel region and separated from said NMOS channel region by a gate oxide layer, and said PMOS transistor has a PMOS gate formed above a PMOS channel region and separated from said PMOS channel region by said gate oxide layer, wherein said NMOS transistor and said PMOS transistor are framed by first field oxide regions, and wherein said source and drain regions of said NMOS transistor and said PMOS transistor comprise source and drain contacts; said high definition, high resistance resistor comprising a resistive region, resistor contact regions and self-aligned resistor contacts affixed to said resistor contact regions, all formed in said epitaxial layer of N type semiconductor material, and a resistor PWell of P type semiconductor material underlying said resistive region and said self-aligned resistor contacts, said resistor structure being framed by a second field oxide region located between said resistor structure and adjacent structures.

12. The high definition, high resistance resistor structure as claimed in Claim **11** wherein said LDD regions of said CMOS transistor structure and said resistive region of said high definition, high resistance resistor structure are formed simultaneously by shallowly implanting an N⁻ concentration of relatively fast-diffusing N type atoms in active areas of said PMOS transistor and said NMOS transistor, and in said resistor PWell.

13. The high definition, high resistance resistor structure as claimed in Claim **12** wherein said relatively fast-diffusing N type atoms are Phosphorus atoms implanted at 1.3x10¹³ ions/cm² @ 60 Kev.

14. A process for fabricating a high definition, high resistance resistor structure, said high definition, high resistance resistor structure comprising a resistive region, resistor contact regions and self-aligned resistor contacts affixed to said resistor contact regions, all formed in an epitaxial layer of N type semiconductor material over a substrate of P type material, and a resistor PWell of P type semiconductor material underlying said resistive region and said self-aligned resistor contacts, said resistor structure being framed by field oxide regions located between said resistor structure and adjacent structures, the process comprising the steps of:
a. forming a resistor PWell by implanting relatively fast-diffusing P type atoms through a resistor PWell defining opening in a PWell definition mask and into said substrate;
b. depositing a polycrystalline layer of semiconductor material over said MOS transistor, said resistor PWell and said field oxide regions;
c. forming said resistive region by shallowly implanting said relatively fast-diffusing N type atoms through a resistive region-definition opening in a MOS poly gate definition mask and into said resistor PWell;
d. forming said resistor contact regions by shallowly implanting relatively slow-diffusing N⁺ type atoms through resistor contact regions-definition openings of a MOS source and drain definition mask;
e. forming said self-aligned resistor contacts using a MOS source and drain contacts definition mask, etch and deposition sequence; and
f. depositing a refractory metal on said self-aligned resistor contacts using a Metal 1 contact definition mask, etch and deposition sequence.

15. The process for fabricating a high definition, high resistance resistor structure as claimed in Claim **14** wherein said relatively fast-diffusing N type atoms are Phosphorus atoms implanted at 1.3x10¹³ ions/cm² @ 60 Kev, and said relatively slow-diffusing N⁺ type atoms are Arsenic atoms.

16. An integrated circuit fabrication process for fabricating a high definition, high resistance resistor structure coupled with an integrated circuit, said integrated circuit comprising a CMOS transistor structure, said CMOS transistor structure comprising a PMOS transistor and an NMOS transistor formed in an epitaxial layer of N type semiconductor material deposited over a P type substrate, wherein said PMOS transistor and said NMOS transistor each has a source region, a drain region and a transistor channel region located between said source region and said drain region, wherein said NMOS transistor has an NMOS gate formed above an NMOS channel region and separated from said NMOS channel region by a gate oxide layer, and said PMOS transistor has a PMOS gate formed above a PMOS channel region and separated from said PMOS channel region by said gate oxide layer, wherein said NMOS transistor and said PMOS transistor are framed by first field oxide regions; said high definition, high resistance resistor structure comprising a resistive region and self-aligned resistor contacts formed in said epitaxial layer of N type semiconductor material, and a resistor PWell underlying said resistive region and said resistor contacts, said resistor structure being framed by a second field oxide region, wherein said CMOS transistor structure is fabricated by a process comprising the steps of:
a. forming a CMOS PWell of said CMOS transistor structure in said P type substrate using a PWell definition mask and etch sequence and implanting relatively fast-diffusing P type atoms through a PWell-defining opening in said PWell definition mask;
b. depositing said N type epitaxial layer over an NWell of said CMOS transistor structure and over said PWell;
c. depositing a polycrystalline layer of semiconductor material over said CMOS transistor structure and said first field oxide regions;
d. forming said PMOS gate and said NMOS gate from said polycrystalline layer using a poly gate definition mask and etch sequence;
e. forming low density drain (LDD) regions in said PMOS transistor and said NMOS transistor using said poly gate definition mask to shallowly implant relatively fast-diffusing N type atoms through LDD region definition openings of said poly gate definition mask, through said gate oxide layer and into said NWell and said PWell, wherein said NMOS gate and said PMOS gate mask the implantation of said relatively fast-diffusing N type atoms into said NMOS channel region and said PMOS channel region respectively;
f. forming NMOS source and drain regions using an NMOS source and drain mask and etch sequence and implanting relatively slow-diffusing N⁺ type atoms into said LDD regions of said NMOS transistor through an NMOS source and drain region-definition opening of said NMOS source and drain definition mask;
g. forming self-aligned CMOS source and drain contacts of said PMOS source and drain regions and NMOS source and drain regions using a CMOS source and drain contacts definition mask, etch and deposition sequence;
h. depositing a refractory metal on said CMOS source and drain contacts of said CMOS transistor structure, wherein said refractory metal is deposited by a Metal 1 contact definition mask, etch and deposition sequence; and
i. modifying said PWell definition mask, said poly gate definition mask, said NMOS source and drain mask, and said CMOS source and drain contacts definition mask so as to form said resistor PWell, said resistive region, and said self-aligned resistor contacts as part of CMOS fabrication.

17. A CMOS integrated circuit photodefinition mask means for fabrication of a high definition, high resistance resistor structure while also fabricating a CMOS transistor structure, said CMOS transistor structure comprising a PMOS transistor and an NMOS transistor formed in an epitaxial layer of N type semiconductor material deposited over a P type substrate, wherein said PMOS transistor and said NMOS transistor each has a source region, a drain region and a transistor channel region located between said source region and said drain region, wherein said NMOS transistor has an NMOS gate formed above an NMOS channel region and separated from said NMOS channel region by a gate oxide layer, and said PMOS transistor has a PMOS gate formed above a PMOS channel region and separated from said PMOS channel region by said gate oxide layer, wherein said NMOS transistor and said PMOS transistor are framed by first field oxide regions; said high definition, high resistance resistor structure comprising a resistive region and self-aligned resistor contacts formed in said epitaxial layer of N type semiconductor material, and a resistor PWell underlying said resistive region and said resistor contacts, said resistor structure being framed by a second field oxide region, said photodefinition mask means comprising:
a. a retro PWell definition mask comprising a PWell-defining opening and a resistor PWell defining opening for simultaneously implanting a CMOS PWell and said resistor PWell in said substrate;
b. a poly gate definition mask comprising LDD region definition openings and resistive region definition openings for simultaneously implanting 1) an LDD region in active areas of said NMOS transistor and said PMOS transistor and 2) said resistive region in said resistor PWell;
c. an NMOS source and drain mask comprising an NMOS source and drain region-definition opening and a resistor contacts region definition opening for simultaneously implanting source and drain regions of said NMOS transistor and said resistor contact regions of said resistor structure;
d. a CMOS source and drain contacts definition mask comprising CMOS source and drain contacts definition openings and resistor contacts definition openings for simultaneously depositing CMOS contacts and resistor contacts; and
e. a Metal 1 contact definition mask comprising CMOS Metal 1 contact definition openings and resistor Metal 1 contact definition openings for depositing Metal 1 contacts on said CMOS transistor structure and said resistor structure.

18. A process for fabricating a high definition, high resistance resistor structure, said resistor structure comprising a resistive region, resistor contact regions and resistor contacts affixed to said resistor contact regions, the process comprising the steps of:
a. forming a resistor well by introducing relatively fast-diffusing atoms of first type conductivity through a resistor well definition mask and into a semiconductor substrate and separating said resistor well from other active regions of said semiconductor substrate by field oxide regions using a CMOS active area definition mask;
b. depositing a polycrystalline layer of semiconductor material over said resistor well and said field oxide regions;
c. forming said resistive region by introducing a shallow layer of relatively fast-diffusing atoms of second type conductivity through a resistive region definition opening of a CMOS poly gate definition mask into said resistor well;
d. forming said resistor contact regions by introducing a shallow layer of slow-diffusing atoms of second type conductivity through resistor contact region definition openings of a CMOS source and drain definition mask into said resistive region;
e. forming said resistor contacts on said resistor contact regions using a CMOS source and drain contacts definition mask, etch and deposition sequence; and
f. depositing a refractory metal on said resistor contacts using a Metal 1 contact definition mask, etch and deposition sequence.

19. The process for fabricating a high definition, high resistance resistor structure as claimed in Claim **18** wherein said semiconductor substrate is an N type semiconductor material.

20. The process for fabricating a high definition, high resistance resistor structure as claimed in Claim **18** wherein said semiconductor substrate is a P type semiconductor material.

21. The process for fabricating a high definition, high resistance resistor structure as claimed in Claim **18** wherein said relatively fast-diffusing atoms are P type atoms.

22. The process for fabricating a high definition, high resistance resistor structure as claimed in Claim **18** wherein the step of forming said resistor well comprises implanting said relatively fast-diffusing atoms of first type conductivity into said semiconductor substrate.

23. The process for fabricating a high definition, high resistance resistor structure as claimed in Claim **18** wherein the step of forming said resistive region comprises implanting said relatively fast-diffusing atoms of second type conductivity into said resistor well.

24. The process for fabricating a high definition, high resistance resistor structure as claimed in Claim **18** wherein the step of forming said resistor contact regions comprises implanting said slow-diffusing atoms of second type conductivity into said resistive region.
